# EUROPEAN PATENT APPLICATION

(11) **EP 2 360 290 A1**
(43) Date of publication of application: **24.08.2011**
(21) Application number: 10153359.4
(22) Date of filing: 11.02.2010
(51) Int. Cl.: C23C 14/08, C23C 14/34, C23C 14/35

(54) **Method for producing an ITO layer and sputtering system**

(71) Applicant: Applied Materials, Inc., Santa Clara, CA 95054 (US)
(72) Inventor: Hellmich, Anke, 63796 Kahl (DE); Schnappenberger, Frank, 55218 Ingelheim (DE); Krempel-Hesse, Joerg, 63694 Limeshain (DE)
(74) Representative: Zimmermann & Partner

(57) **Abstract**

The present disclosure relates to a method for producing an indium-tin-oxide layer, comprising: providing a substrate to be coated in a sputtering chamber; providing a rotatable non-bonded target around a backing tube for coating the substrate in the sputtering chamber; and sputtering the material from the target in an atmosphere containing an O₂/H₂ mixture. Further, the present disclosure relates to a sputtering system comprising a sputtering chamber having at least one gas inlet and being adapted for at least one backing tube for a non-bonded rotatable target, a control device adapted to control the flow through the gas inlet, wherein the control device is adapted to control the at least one gas inlet such that a coating on a substrate using a sputtering process is performed in an atmosphere containing an O₂/H₂ mixture in the sputtering chamber for forming an indium-tin-oxide layer.

## Description

The present disclosure relates to a method for producing an indium-tin oxide layer. More specifically the present disclosure relates to a sputtering system.

### BACKGROUND

In many applications, it is necessary to deposit thin layers on a substrate. The term "substrate" as used herein shall embrace both inflexible substrates, e.g., a wafer or a glass plate and flexible substrates, for example, webs and foils. Typical techniques for depositing layers are evaporating, sputtering and chemical vapor deposition.

Representative examples include (but are not limited to) applications involving: semiconductor and dielectric materials and devices, silicon-based wafers, flat panel displays, masks and filters, energy conversion and storage (such as photovoltaic cells, fuel cells, and batteries), solid-state lighting (such as LEDs and OLEDs), magnetic and optical storage, micro-electro-mechanical systems (MEMS) and nano-electro-mechanical systems (NEMS), micro-optic and opto-elecro-mechanical systems (NEMS), micro-optic and optoelectronic devices, transparent substrates, architectural and automotive glasses, metallization systems for metal and polymer foils and packaging, and micro- and nano-molding.

Sputtering is a vacuum coating process used to deposit thin films of various materials onto the surface of a substrate. For example, sputtering can be used to deposit ceramics. During the sputtering process, the coating material is transported from a target to the substrate to be coated by bombarding the surface of the target with ions of an inert gas, which have been accelerated by a high voltage. When the gas ions hit the outer surface of the target, their momentum is transferred to the atoms of the material so that some of them can gain sufficient energy to overcome their bonding energy in order to escape from the target surface and to deposit on the substrate. Thereon, they form a film of the desired material. The thickness of the deposited film is, inter alia, dependent on the duration of the substrate's exposure to the sputtering process.

Typically, sputtering systems are used to coat substrates, for example, window paints, semiconductor devices, displays, and the like. Typically plasma is formed in a sputtering chamber in which the sputtering target is disposed. For example, rotating sputtering targets may be used. Typically, the rotating sputtering targets have a cylindrical form and rotate about their longitudinal axis. The sputtering targets are disposed on a backing tube in which magnetrons may be arranged.

### SUMMARY

In light of the above, a method for coating an indium-tin-oxide layer according to independent claim 1 and a sputtering system according to claim 12 are provided.

According to one aspect, a method for producing an indium-tin-oxide layer is provided, including providing a substrate to be coated in a sputtering chamber; providing a rotatable non-bonded target around a backing tube for coating the substrate in the sputtering chamber; and sputtering the material from the target in an atmosphere containing an O₂/H₂ mixture.

In a typical embodiment, the material is sputtered from an indium-tin-oxide target.

For example, in an embodiment, which may be combined with other embodiments disclosed herein, the indium-tin-oxide layer is amorphous. In a typical embodiment, the indium-tin-oxide layer is amorphous before an annealing of the indium-tin-oxide layer.

In a typical embodiment, which may be combined with other embodiments disclosed herein, the transmittance of the indium-tin-oxide layer for light of a wavelength between about 400 nm and about 700 nm is on average about 2%, or, in particular, more than about 2%, greater than the transmittance of an indium-tin-oxide layer deposited with the same process without H₂. In particular, in a typical embodiment, the transmittance is provided after an annealing of the indium-tin-oxide layer.

For example, in an embodiment, the molecular rate in the sputtering chamber during sputtering between H₂ and O₂ is between 1:1 and 3:1, in particular about 2:1.

In a typical embodiment, the H₂ and O₂ are fed separately into the sputtering chamber.

For example, in an embodiment, the O₂ is fed in an Ar/O₂ mixture into the sputtering chamber.

In a typical embodiment, the Ar/O₂ mixture has a molecular rate of about 80:20 to about 90:10.

In a typical embodiment, which may be combined with other embodiments disclosed herein, the H₂ is fed in an Ar/H₂ mixture into the sputtering chamber.

In a typical embodiment, the Ar/H₂ mixture has a molecular rate of about 90:10 to about 99:1.

In an embodiment, which may be combined with other embodiments disclosed herein, the target has during sputtering of the material from the target a temperature of more than 200°C, in particular of more than 300°C, for example, more than 400°C.

For example, in an embodiment, the method includes adjusting the pressure in the sputtering chamber between about 10⁻⁴ and about 5* 10⁻² mbar, in particular between about 8* 10⁻⁴ and about 10⁻² mbar.

According to a further aspect, a sputtering system including a sputtering chamber is provided having at least one gas inlet and being adapted for at least one backing tube for a non-bonded rotatable target, a control device adapted to control the flow through the gas inlet, wherein the control device is adapted to control the at least one gas inlet such that a coating on a substrate using a sputtering process is performed in an atmosphere containing an O₂/H₂ mixture in the sputtering chamber for forming an indium-tin-oxide layer.

For example, in an embodiment, the control device is adapted to control the molecular rate in the sputtering chamber during sputtering between H₂ and O₂ is between 1:1 and 3:1, in particular about 2:1.

In a typical embodiment, which may be combined with other embodiments disclosed herein, the sputtering chamber includes at least two gas inlets, one for H₂ and one for O₂.

For example, in an embodiment, an O₂ source, in particular an Ar/O₂ source, connected to the gas inlet for O₂.

In an embodiment, the O₂ source is adapted to provide the Ar/O₂ mixture with a molecular rate of about 80:20 to about 90:10.

For example, the sputtering chamber may further include an H₂ source, in particular an Ar/H₂ source, connected to the gas inlet for H₂.

In a typical embodiment, the H₂ source is adapted to provide the Ar/H₂ mixture with a molecular rate of about 90:10 to about 99:1.

For example, in an embodiment, an indium-tin-oxide target is disposed around the backing tube.

In an embodiment, which may be combined with other embodiments disclosed herein, the sputtering system is adapted to perform the method according to an embodiment disclosed herein.

In a typical embodiment, which may be combined with other embodiments disclosed herein, the method may include an annealing of the coating.

In a typical embodiment, the backing tube is adapted for one or more non-bonded target cylinders to be disposed around the tube, the tube having an exterior surface adapted to face the at least one target cylinder and at least three or more protrusion receiving positions; and protrusions mounted on the exterior surface of the tube at each of the protrusion receiving positions for centering the target cylinders.

For example, in an embodiment, at least three protrusions per target cylinder are mounted on the exterior surface for supporting and centering the target cylinders when the target cylinders are arranged for a sputtering operation on the target backing tube.

For example, in an embodiment, the at least one protrusion is selected from the group consisting of: a nose; a resilient member, in particular a spring; a circular spring that is arranged substantially circumferential, a solid center element with a support surface and combinations thereof.

In an embodiment, which may be combined with other embodiments disclosed herein, the tube includes a recess, in particular a circular groove, at least at one, in particular at each protrusion receiving position for a particular target cylinder when arranged for a sputtering operation on the tube, wherein the at least one protrusion is arranged in the recess.

Further aspects, advantages and features of the present invention are apparent from the dependent claims, the description and the accompanying drawings.

### BRIEF DESCRIPTION OF THE DRAWINGS

A full and enabling disclosure including the best mode thereof, to one of ordinary skill in the art, is set forth more particularly in the remainder of the specification, including reference to the accompanying figures wherein:
Fig. 1 shows a schematical cross-sectional view of an embodiment of a sputtering system;
Fig. 2 shows a flow chart of a method for producing an indium-tin-oxide layer.

### DETAILED DESCRIPTION

Reference will now be made in detail to the various embodiments, one or more examples of which are illustrated in each figure. Each example is provided by way of explanation and is not meant as a limitation. For example, features illustrated or described as part of one embodiment can be used on or in conjunction with other embodiments to yield yet further embodiments. It is intended that the present disclosure includes such modifications and variations.

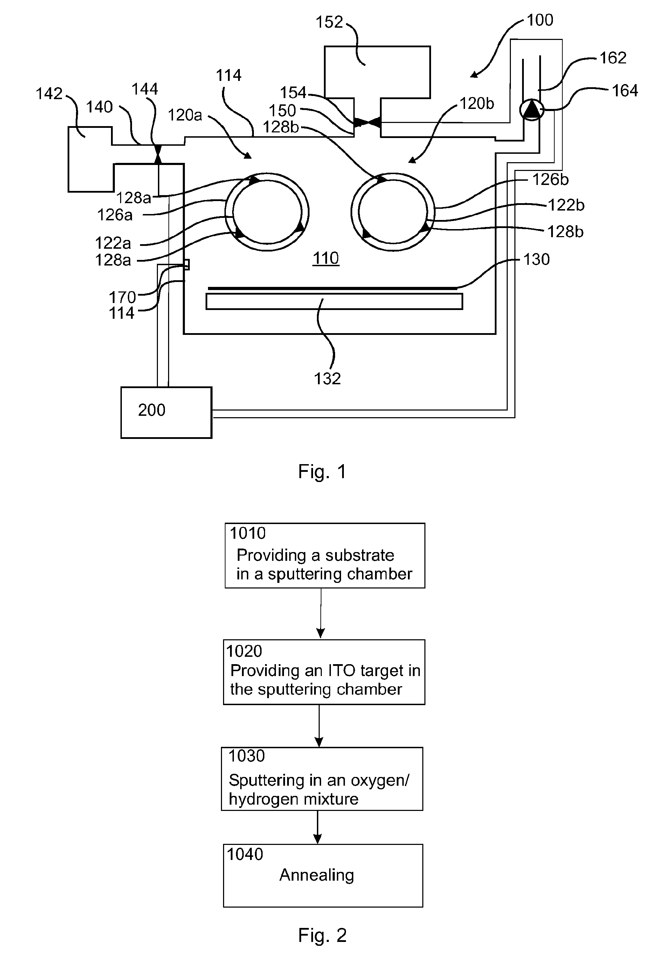

Referring to the drawings, where like or similar elements are designated with identical reference numbers throughout the different figures, Fig. 1 shows a schematic cross-section of a sputtering system 100 having a sputtering chamber 110. The sputtering chamber is limited by sputtering chamber walls 114. In a typical embodiment, the sputtering system 100 includes two rotating cylindrical target assemblies 120a, 120b. In other embodiments, which may be combined with other embodiments disclosed herein, the sputtering system may include one, three, four or more cylindrical target assemblies. In a typical embodiment, which may be combined with other embodiments disclosed herein, the rotating cylindrical target assemblies 120a, 120b are driven by a drive assembly not shown in Fig. 1. The rotating cylindrical target assemblies 120a, 120b each include a backing tube 122a, 122b in which magnet arrangements and a cathode (not shown) are disposed. Further, cylindrical target elements 126a, 126b are disposed around the backing tube 122a, 122b. For example, in a typical embodiment, which may be combined with other embodiments disclosed herein, the cylindrical target elements 126a, 126b may be not bonded to the respective backing tube 122a, 122b. In a typical embodiment, a plurality of distance pieces 128a, 128b, in particular resilient distance pieces 128a, 128b, are disposed on the backing tube 122a, 122b for centering and supporting the target elements 126a, 126b. In a typical embodiment, the resilient distance pieces may be springs. Thus, during sputtering the target elements 126a, 126b are substantially not cooled, for example, by the cooling system of the backing tube, such that the target elements 126a, 126b may reach a high temperature, for example, of more than 200°C, in particular of more than 400°C. The cylindrical target elements 126a, 126b may be exchanged after they have been used up. In a typical embodiment, the indium tin oxide (ITO) targets may be used as target elements. In Fig. 1, horizontal rotating cylindrical target assemblies are shown. In some embodiments, which may be combined with other embodiments disclosed herein, vertical cylindrical target assemblies may be used.

The sputtering chamber 110 further includes a first inlet port 140, which is connected to a first gas source 142. The first gas source may be, in a typical embodiment, an argon/hydrogen (H₂) mixture. For example, the argon/H₂ mixture may be provided in a molecular rate of 90:10 to about 99:1, in particular 92:8 to about 97:3. Further, a valve 144 or a pump may be disposed in a fluid or gas connection between the argon/H₂ source and the sputtering chamber 110 for controlling the flow rate and/or the quantity of the argon/H₂ mixture provided to sputtering chamber 110.

The sputtering chamber 110 further includes a second inlet port 150, which is connected to a second gas source 152. The second gas source may be, in a typical embodiment, an argon/oxygen (O₂) mixture. For example, the argon/O₂ mixture may be provided in a molecular rate of 80:20 to about 90:10, in particular 83:17 to about 87:13. Further, a valve 154 or a pump may be disposed in a fluid or gas connection between the argon/O₂ source and the sputtering chamber 110 for controlling the flow rate or the quantity of the argon/O₂ mixture provided to sputtering chamber 110.

Further, the sputtering chamber may include an outlet port 160, connected to an outlet conduit 162, which is in fluid connection with an outlet pump 164 for providing the vacuum in the sputtering chamber 110.

Further, a sensor 170 is provided in the sputtering chamber 110 for providing information to determine the amount of oxygen, argon and/or hydrogen in the sputtering chamber. The sensor 170, the first valve 144, the second valve 154, and the outlet pump 164 are connected, in a typical embodiment, to a control device 200. The control device 200 may control the valves 144, 154 and the pump 164, so that a desired atmosphere is created and maintained in the sputtering chamber 110.

Further, in the sputtering chamber 110, a substrate 130 is disposed below the cylindrical target assemblies 120a, 120b. The substrate 130 may be arranged, in a typical embodiment, which may be combined with other embodiments disclosed herein, on a substrate support 132. In a typical embodiment, which may be combined with other embodiments disclosed herein, a substrate support device for a substrate to be coated is disposed in the sputtering chamber. For example, the substrate support device may include conveying rolls, magnet guiding systems and further features.

In further embodiments, the sputtering chamber may include substrate drive systems for driving a substrate to be coated 130 in or out of the sputtering chamber 110. For that reason, the sputtering chamber may include a vacuum lock chamber disposed at a wall of the sputtering chamber 110. In an embodiment, which may be combined with other embodiments disclosed herein, the rotating axis of the cylindrical target assemblies 120a, 120b are substantially parallel.

In operation, a plasma is formed inside the sputtering chamber 110 between the cylindrical target assembly and an anode by exciting a sputtering gas. In a typical embodiment, the anode is disposed below the substrate to be coated. In a typical embodiment, the sputtering gas includes argon. Also other inert gases may be used in some embodiments for sputtering.

For providing an amorphous indium-tin-oxide (ITO) layer having a low film stress and a high transmissivity an atmosphere containing hydrogen and oxygen is provided in the sputtering chamber and an ITO layer is sputtered with a non-bonded rotary target. For example, the indium-tin-oxide layer may have a film stress from about -350MPa to about 350MPa. Typically, the transmissivity of the indium-tin-oxide layer for light of a wavelength between about 400 nm and about 700 nm is on average about 2%, or, in particular, more than about 2%, greater than the transmittance of an indium-tin-oxide layer deposited with the same process without H₂. In a typical embodiment, the increased transmittance of the indium-tin-oxide layer is provided after an annealing of the indium-tin-oxide layer. The ITO layer is typically provided on the substrate 130. Typically, the layer coated on the substrate 130 is amorphous.

An embodiment of a method for providing an amorphous ITO layer is explained with respect to Fig. 2. As indicated in Fig. 2, in a first box 1010, a substrate is provided in a sputtering chamber for being coated with an ITO layer. Typically, also a target, in particular an ITO target, is provided in box 1020 in the sputtering chamber. In another embodiment, the target is already provided in the sputtering chamber when the substrate to be coated is provided in the sputtering chamber or positioned below the cylindrical target assemblies.

Then, see box 1030, a plasma is created in the sputtering chamber and the target is sputtered. During the sputtering process, an atmosphere is created in sputtering chamber 110 that contains an O₂/H₂ or oxygen/hydrogen mixture. Typically, during sputtering of the ITO layer, the molecular rate between oxygen and hydrogen is between 1:1 and 1:3, in particular about 1:2.

In a further embodiment, which may be combined with other embodiments disclosed herein, water is provided as gas to the sputtering chamber 110. Thus, the sputtering system 100 may include a water source and a heating device for generating steam that is then provided via a fluid or gas connection to the sputtering chamber 110. Due to the plasma, the water is split into oxygen and hydrogen molecules.

In a typical embodiment, which may be combined with other embodiments disclosed herein, after the deposition of the ITO layer on the substrate, an annealing of the ITO layer, in particular the amorphous ITO layer, is performed (see box 1040).

Typically, after deposition and after annealing, a low stress layer is possible. Hence, in a method according to an embodiment, which may be combined with another embodiment disclosed herein, a high transmissive layer is possible. Hence, the production of a special property ITO layer with a non-bonded rotary target is provided.

This written description uses examples to disclose the invention, including the best mode, and also to enable any person skilled in the art to practice the described subject-matter, including making and using any devices or systems and performing any incorporated methods. While various specific embodiments have been disclosed in the foregoing, those skilled in the art will recognize that the spirit and scope of the claims allow for equally effective modifications. Especially, mutually non-exclusive features of the embodiments described above may be combined with each other. The patentable scope is defined by the claims, and may include such modifications and other examples that occur to those skilled in the art. Such other examples are intended to be within the scope of the claims if they have structural elements that do not differ from the literal language of the claims, or if they include equivalent structural elements with insubstantial differences from the literal language of the claims.

## Claims

1. Method for producing an indium-tin-oxide layer, comprising providing a substrate (130) to be coated in a sputtering chamber;
providing a rotatable non-bonded target (126a, 126b) around a backing tube (122a, 122b) for coating the substrate in the sputtering chamber (110); and
sputtering the material from the target in an atmosphere containing an O₂/H₂ mixture.

2. Method according to claim 1, wherein
the material is sputtered from an indium-tin-oxide target.

3. Method according to claim 1 or 2, wherein
the indium-tin-oxide layer is amorphous.

4. Method according to one of the preceding claims, wherein
the transmittance of the indium-tin-oxide layer for light of a wavelength between about 400 nm and about 700 nm is in average about 2%, or in particular more than about 2%, greater than the transmittance of an indium-tin-oxide layer deposited with the same process without H₂.

5. Method according to one of the preceding claims, wherein
molecular rate in the sputtering chamber during sputtering between H₂ and O₂ is between 1:1 and 3:1, in particular about 2:1.

6. Method according to one of the preceding claims, wherein
the H₂ and O₂ is fed separately into the sputtering chamber.

7. Method according to one of the preceding claims, wherein
the O₂ is fed in an Ar/O₂ mixture into the sputtering chamber, wherein in particular the Ar/O₂ mixture has a molecular rate of about 80:20 to about 90:10.

8. Method according to one of the preceding claims, wherein
the H₂ is fed in an Ar/H₂ mixture into the sputtering chamber, wherein in particular the Ar/H₂ mixture has a molecular rate of about 90:10 to about 99:1.

9. Method according to one of the preceding claims, wherein
the target has during sputtering of the material from the target a temperature of more than 200°C, in particular of more than 300°C, for example more than 400°C.

10. Sputtering system comprising a
sputtering chamber (110) having at least one gas inlet (140, 150) and being adapted for at least one backing tube (122a, 122b) for a non-bonded rotatable target (126a, 126b), a control device (200) adapted to control the flow through the gas inlet, wherein
the control device is adapted to control the at least one gas inlet such that a coating on a substrate using a sputtering process is performed in an atmosphere containing an O₂ /H₂ mixture in the sputtering chamber for forming an indium-tin-oxide layer.

11. Sputtering system according to claim 10, wherein
the sputtering chamber comprises at least two gas inlets (140, 150), one for H₂ and one for O₂.

12. Sputtering system according to one of the claims 10 to 11, further comprising an O₂ source (152), in particular an Ar/O₂ source, connected to the gas inlet for O₂ and/or an H₂ source, in particular an Ar/H₂ source, connected to the gas inlet for H₂.

13. Sputtering system according to one of the claims 10 to 12, wherein
the backing tube is adapted for one or more non-bonded target cylinders to be disposed around the tube, the tube having an exterior surface adapted to face the at least one target cylinder and at least three or more protrusion receiving positions; and protrusions (128a, 128b) mounted on the exterior surface of the tube at each of the protrusion receiving positions for centering the target cylinders.

14. Sputtering system according to one of the claims 10 to 13, wherein
an indium-tin-oxide target (126a, 126b) is disposed around the backing tube.

15. Sputtering system according to one of the claims 10 to 14, adapted to perform the method according to one of the claims 1 to 8.
